# EUROPEAN PATENT APPLICATION

(11) **EP 4 838 559 A1**
(43) Date of publication of application: **11.11.2026**
(21) Application number: 24915616.7
(22) Date of filing: 18.12.2024
(51) Int. Cl.: H01L 23/40, H01L 23/367

(54) **CHIP PACKAGE STRUCTURE AND ELECTRONIC APPARATUS**

(30) Priority: 05.01.2024 CN 202410022412
(71) Applicant: Cloud Intelligence Assets Holding (Singapore) Private Limited, Singapore 189554 (SG)
(72) Inventor: HE, Yongbao, ShenZhen, Guangdong 518052 (CN); ZHONG, Yangfan, ShenZhen, Guangdong 518052 (CN); CHEN, Xianfeng, ShenZhen, Guangdong 518052 (CN)
(74) Representative: 2SPL Patentanwälte PartG mbB
(86) International application number: PCT/IB2024/062796
(87) International publication number: WO 2025/146592

(57) **Abstract**

Provided in the present application are a chip package structure and an electronic apparatus. The chip package structure comprises: a bare chip and a chip press-fitting plate. The bare chip is mounted on a circuit board by means of a mounting base. The mounting base comprises a plurality of flexible contact terminals used for abutting against the bare chip, so that a communication line is formed between the bare chip and the circuit board by means of the flexible contact terminals. The chip press-fitting plate is used for press-fitting the bare chip onto the mounting base, and the chip press-fitting plate is connected to a heatsink. When the chip press-fitting plate is used for press-fitting the bare chip onto the mounting base, the heatsink can move relative to the chip press-fitting plate on the basis of a generated mounting stress, and the heatsink and an upper surface of the bare chip are kept in an abutting state so as to conduct a heat dissipation operation on the bare chip.

## Description

### TECHNICAL FIELD

This disclosure relates to the field of chip package, and in particular, to a chip package structure and an electronic apparatus.

### BACKGROUND

With the rapid development of electronic technologies, chips are applied increasingly widely. During use of a chip, the chip generates a specific amount of heat. If the heat cannot be dissipated in time, normal operation of the chip may be affected.

The chip typically includes a bare chip and a metal cover disposed outside the bare chip. The metal cover is configured to protect the bare chip. To address a heat dissipation problem of the chip, the metal cover may be removed, thereby allowing a heat sink to be in direct contact with the bare chip. This not only enhances a heat dissipation capability, but also reduces chip costs.

However, for the chip, because the bare chip loses protection by the metal cover, a capability of withstanding external influences is greatly reduced. Consequently, the bare chip is easily damaged during assembly, resulting in increased manufacturing costs of an electronic apparatus.

### SUMMARY

Embodiments of the present disclosure provide a chip package structure and an electronic apparatus, which can not only ensure heat dissipation quality and effectiveness of a chip, but also implement a stable and reliable mounting operation on a bare chip.

According to a first aspect, an embodiment of the present disclosure provides a chip package structure, including: a bare chip mounted on a circuit board through a mounting base, where the mounting base includes a plurality of flexible contact terminals configured to abut against the bare chip, to enable the bare chip to form a connecting line with the circuit board through the flexible contact terminals; and a chip withholding plate configured to press-mount the bare chip onto the mounting base, where the chip withholding plate is connected to a heat sink, and when the chip withholding plate is used to press-mount the bare chip onto the mounting base, the heat sink is capable of moving relative to the chip withholding plate based on a mounting stress generated from press-mounting the bare chip onto the mounting base, and the heat sink remains in abutment with an upper surface of the bare chip to perform a heat dissipation operation on the bare chip.

In some examples, a direction in which the heat sink moves relative to the chip withholding plate is opposite to a mounting direction of the bare chip.

In some examples, the mounting base is a land grid array socket, and the mounting base is fixedly mounted on the circuit board.

In some examples, the package structure further includes a chip metal ring connected to the bare chip, where the bare chip is disposed at a central portion of the chip metal ring, to abut against the flexible contact terminals through the chip metal ring.

In some examples, the chip withholding plate is mounted on the circuit board through a detachable connecting member.

In some examples, the detachable connecting member is provided with a first elastic member, and the first elastic member is configured to absorb a mounting tolerance in a process of mounting of the bare chip onto the circuit board.

In some examples, the chip withholding plate is movably connected to the heat sink through a detachable connecting member, and an upper end of the detachable connecting member is provided with a limiting member, where the limiting member is configured to limit a range within which the heat sink moves relative to the chip withholding plate.

In some examples, the detachable connecting member includes any one of: a connecting column, and a spring connecting member.

In some examples, when the detachable connecting member is the connecting column, the connecting column is provided with a second elastic member.

In some examples, the heat sink includes a heat dissipation boss configured to abut against the upper surface of the bare chip, the chip withholding plate is provided with a mounting through hole corresponding to the heat dissipation boss, and the heat dissipation boss abuts against the upper surface through the mounting through hole.

In some examples, a size of the heat dissipation boss is same as or different from a size of the upper surface.

In some examples, a plurality of bare chips are provided, the heat sink includes a plurality of heat dissipation bosses configured to perform the heat dissipation operation on the plurality of bare chips, and heights of the plurality of heat dissipation bosses are same or different.

In some examples, the heat sink abuts against the upper surface of the bare chip through a heat conductive member.

According to a second aspect, an embodiment of the present disclosure provides an electronic apparatus, including: a base plate; and the chip package structure according to the first aspect, where the package structure is detachably mounted on the base plate.

A chip package structure and an electronic apparatus provided in this embodiment include a bare chip and a chip withholding plate. The bare chip may be mounted on a circuit board through a mounting base provided with flexible contact terminals. Specifically, the bare chip is press-mounted onto the mounting base through the chip withholding plate. In addition, a heat sink may be used to perform a heat dissipation operation on the bare chip. This effectively enables the heat sink to continuously perform the heat dissipation operation on the bare chip while the chip withholding plate is used to press-mount the bare chip onto the mounting base, thereby ensuring safe and reliable operation of the bare chip. Moreover, because the heat sink can move relative to the chip withholding plate based on a generated mounting stress, the chip withholding plate and the heat sink do not exert a large mounting pressure on the bare chip, to prevent damage to the bare chip, thereby reducing manufacturing costs of the package structure, ensuring stable and reliable use of the bare chip, and further enhancing practicality of the package structure.

### BRIEF DESCRIPTION OF DRAWINGS

To describe the technical solutions of embodiments of the present disclosure or the related art more clearly, the following briefly introduces accompanying drawings required for describing the embodiments or the related art. Apparently, the accompanying drawings in the following descriptions show some embodiments of the present disclosure, and a person of ordinary skill in the art may still derive other drawings from these accompanying drawings without creative efforts.
FIG. 1 is a schematic structural diagram 1 of a chip package structure according to an embodiment of the present disclosure.
FIG. 2 is a schematic structural diagram of a bare chip abutting against flexible contact terminals according to an embodiment of the present disclosure.
FIG. 3 is a schematic structural diagram 2 of a chip package structure according to an embodiment of the present disclosure.
FIG. 4 is a schematic structural diagram 1 of a connection between a chip withholding plate and a heat sink according to an embodiment of the present disclosure.
FIG. 5 is a schematic structural diagram 2 of a connection between a chip withholding plate and a heat sink according to an embodiment of the present disclosure.
FIG. 6 is a schematic structural diagram 3 of a chip package structure according to an embodiment of the present disclosure.
FIG. 7 is a schematic structural diagram of a chip package structure according to an embodiment of the present disclosure.
FIG. 8 is a schematic structural diagram of a circuit board having a heat dissipation function according to an application embodiment of the present disclosure.

### DETAILED DESCRIPTION

To make objectives, technical solutions, and advantages of embodiments of the present disclosure clearer, the following clearly and completely describes the technical solutions in the embodiments of the present disclosure with reference to the accompanying drawings in the embodiments of the present disclosure. Apparently, the described embodiments are some embodiments of the present disclosure, but not all the embodiments. All other embodiments obtained by a person of ordinary skill in the art based on the embodiments of the present disclosure without creative efforts fall within the protection scope of the present disclosure.

In the descriptions of the embodiments of the present disclosure, terms such as "mounting", "connecting", and "fixing" should all be understood in a broad sense. For example, "connecting" may refer to a fixed connection, a detachable connection, or an integral connection. For a person of ordinary skill in the art, the specific meanings of the terms in the embodiments of the present disclosure may be understood according to specific situations.

In the descriptions of the embodiments of the present disclosure, it should be understood that orientations or location relationships indicated by terms such as "center", "longitudinal", "transverse", "length", "width", "thickness", "upper", "lower", "front", "rear", "left", "right", "vertical", "horizontal", "top", "bottom", "inner", and "outer" are as shown in the accompanying drawings, are used merely for the convenience of describing the embodiments of the present disclosure and simplifying the description, instead of indicating or implying that an indicated device or element must have a particular orientation or must be constructed and operated in a particular orientation, and therefore, cannot be understood as a limitation to the embodiments of the present disclosure.

Terms "including" and "having" as well as any of their variants in the specification and claims of the embodiments of the present disclosure are intended to encompass a non-exclusive inclusion. For example, a process including a series of steps or an apparatus including a series of structures is not limited to the explicitly listed steps or structures, but may include other steps or structures that are not explicitly listed or are inherent to the process or the apparatus.

In addition, terms "first" and "second" are used merely for the purpose of description, and shall not be construed as indicating or implying relative importance or implying a quantity of indicated technical features. Therefore, a feature defined by "first" or "second" may explicitly indicate or implicitly include at least one of such features. In the descriptions of the embodiments of the present disclosure, "plurality of" means at least two, such as two, three, etc., unless it is specifically defined otherwise.

In the descriptions of this specification, descriptions of a reference term such as "an embodiment", "some embodiments", "an example", "a specific example", or "some examples" means that a specific feature, structure, material, or characteristic that is described with reference to the embodiment or the example is included in at least one embodiment or example of the embodiments of the present disclosure. In this specification, illustrative descriptions of the foregoing terms are not necessarily directed at the same embodiment or example. Moreover, the specific feature, structure, material, or characteristic described may be combined in any one or more embodiments or examples in a suitable manner. In addition, different embodiments or examples described in this specification, as well as features of different embodiments or examples, may be integrated and combined by a person skilled in the art without contradicting each other.

### Definition of terms:

A bare chip package member is a packaging form in which a bare chip obtained after a wafer is diced is directly packaged on a pcb base plate, to form a chip component having a function of an independent integrated circuit, and a metal cover is not added to protect the bare chip.

A land grid array (LGA) socket is a surface-mount technology for an integrated circuit, pins thereof are located on a socket rather than on the integrated circuit. An LGA-packaged chip can be connected to a printed circuit board through the LGA socket. Compared with a conventional packaging manner in which the pins are disposed on the integrated circuit, this manner may reduce a problem of pin damage and may allow for an increased quantity of pins.

Some implementations of the present disclosure are described in detail below with reference to the accompanying drawings. The following embodiments and features in the embodiments may be mutually combined if no conflict occurs among the embodiments.

To facilitate understanding of specific structural features and structural effects of a chip package structure and an electronic apparatus in the embodiments, brief descriptions of the related art are provided below.

With the development and progress of semiconductor integrated circuit process, the 3 nm and 5 nm processes are gradually matured and applied to design and production of a chip, thereby further improving hardware performance of the chip. However, in addition, a denser integrated circuit causes higher heat generation, and power consumption of the chip becomes larger. Moreover, the size of the chip also becomes larger, and it is more difficult to resolve a heat dissipation problem of the chip.

In a conventional chip package structure, a bare chip needs to be packaged in a metal cover. In this case, to conduct heat away, an interface material referred to as TIM1 needs to be filled between the bare chip and the metal cover for heat conduction; and an interface material referred to as TIM2 is also filled between the metal cover and a heat sink. Through two times of conduction through the interface materials, the heat is transmitted to the heat sink for a heat dissipation operation. However, because the heat of the bare chip is conducted through two layers of the interface materials, a resistance to heat transfer is high. To obtain a better heat conduction capability, the TIM1 material is usually at a high price, greatly affecting manufacturing costs of the chip.

During a packaging operation on the bare chip, to better resolve a heat dissipation problem of the chip, the metal cover may be removed, so that the heat sink is in direct contact with the bare chip, reducing a quantity of layers of the filled interface materials to just one. This manner can significantly lower thermal resistance, improve a heat dissipation capability, and also reduce packaging costs of the bare chip.

However, for the bare chip, because the bare chip loses protection by the metal cover, a capability of withstanding external influences is greatly reduced. Consequently, the bare chip is easily damaged during assembly, resulting in increased packaging and manufacturing costs of the bare chip.

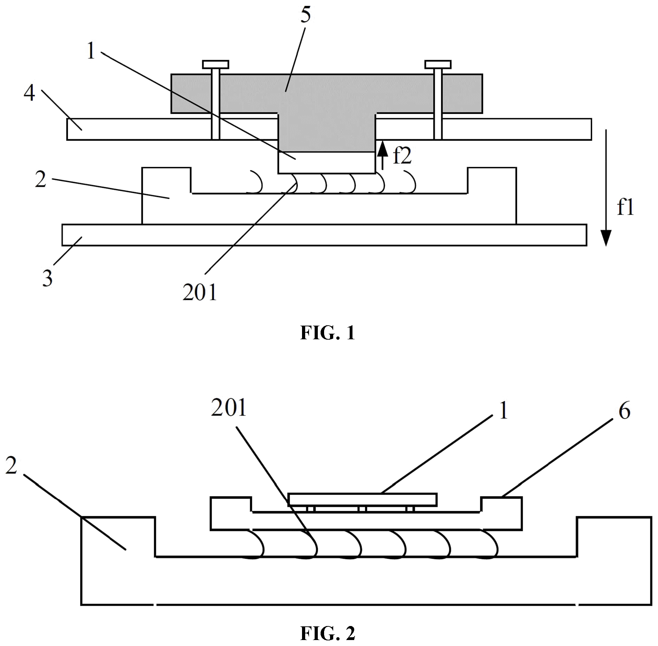

An embodiment of the present disclosure provides a chip package structure, and the package structure may be implemented as a bare chip package member. The chip package structure can not only ensure heat dissipation quality and effectiveness of a chip, but also implement a stable and reliable mounting operation on a bare chip. Specifically, with reference to FIG. 1, the chip package structure in this embodiment may include a bare chip 1 and a chip withholding plate 4.

The bare chip 1 is mounted on a circuit board 3 through a mounting base 2, and the mounting base 2 includes a plurality of flexible contact terminals 201 configured to abut against the bare chip 1, to enable the bare chip 1 to form a connecting line with the circuit board 3 through the flexible contact terminals 201.

The bare chip 1 may be a bare chip obtained after a wafer is diced, and the bare chip 1 may be mounted on the circuit board 3 through the mounting base 2. For the circuit board 3, different application scenarios may correspond to different types of circuit boards 3. For example, the circuit board 3 may be implemented as a printed circuit board (PCB) or a printed circuit board assembly (PCBA). Compared with the PCBA board, the PCB board is an empty printed circuit board, and no component is deployed on the printed circuit board. For the circuit board 3, a person skilled in the art may flexibly select or configure a specific type of the circuit board 3 according to a specific design requirement and application requirement.

For the mounting base 2, the mounting base 2 may include the plurality of flexible contact terminals 201 configured to abut against the bare chip 1. The flexible contact terminals 201 may deform with change of a contact pressure. For example, a larger contact pressure against the flexible contact terminals 201 indicates a larger deformation of the flexible contact terminals 201, and a smaller contact pressure against the flexible contact terminals 201 indicates a smaller deformation of the flexible contact terminals 201.

In addition, different application scenarios may correspond to different types of mounting bases 2, and a person skilled in the art may flexibly configure the mounting base 2 according to a specific application requirement. For example, the mounting base 2 may be implemented as a ball grid array (BGA) socket or a land grid array (LGA) socket. Because LGA packaging process has advantages such as convenient maintenance, low costs, being capable of supporting a plurality of types of chips, and being convenient to perform flexible switching and reconfiguration, the mounting base 2 may be preferably implemented as an LGA socket. In this case, the mounting base 2 may be fixedly mounted on the circuit board 3. For example, the mounting base 2 may be soldered to the circuit board 3, or the mounting base 2 may be fixedly connected to the circuit board 3 through a connecting member or an adhesive, or the mounting base 2 may be in contact with the circuit board 3 through the flexible contact terminals or elastic contact terminals, etc., provided that the mounting base 2 can be ensured to be stably and reliably mounted on the circuit board 3.

The chip withholding plate 4 included in the chip package structure is configured to press-mount the bare chip 1 onto the mounting base 2. The chip withholding plate 4 is connected to a heat sink 5. When the chip withholding plate 4 is used to press-mount the bare chip 1 onto the mounting base 2, the heat sink 5 can move relative to the chip withholding plate 4 based on a generated mounting stress, and the heat sink 5 remains in abutment with an upper surface of the bare chip 1. In some embodiments, the heat sink 5 may directly abut against the bare chip 1, or the heat sink 5 may abut against the upper surface of the bare chip 1 through a heat conductive member or a heat conductive material, to enable the heat sink 5 to perform a heat dissipation operation on the bare chip 1.

For the chip withholding plate 4, the chip withholding plate 4 may be implemented as a regularly-shaped plate-like structure or an irregularly-shaped plate-like structure. The chip withholding plate 4 may press-mount the bare chip 1 onto the mounting base 2, where one or more bare chips 1 may be provided, that is, one chip withholding plate 4 may press-mount one or more bare chips 1 onto the mounting base 2. Connecting lines may be formed between the mounted bare chip 1 and the mounting base 2 through the plurality of flexible contact terminals 201 and between the mounting base 2 and the circuit board 3. In this way, stable application of the bare chip 1 may be implemented.

It should be noted that when the chip withholding plate 4 is used to press-mount the bare chip 1 onto the mounting base 2, to ensure stable and reliable use of the bare chip 1, the heat dissipation operation needs to be performed on the bare chip 1. In this case, the chip withholding plate 4 may be connected to the heat sink 5, and the heat sink 5 can move relative to the chip withholding plate 4 based on the generated mounting stress, that is, a direction in which the heat sink 5 moves relative to the chip withholding plate 4 is opposite to a mounting direction of the bare chip 1. For example, when the chip withholding plate 4 is used to press-mount the bare chip 1 onto the mounting base 2, the bare chip 1 may receive a mounting force in a direction f1. The direction f1 may be referred to as the mounting direction. Because the chip withholding plate 4 is connected to the heat sink 5, and the heat sink 5 remains in abutment with the bare chip 1, the heat sink 5 can maintain the heat dissipation operation on the bare chip 1.

Specifically, when the chip withholding plate 4 is used to press-mount the bare chip 1 onto the mounting base 2, the chip withholding plate 4 moves in the f1 direction. If the chip withholding plate 4 is fixedly connected to the heat sink 5, the heat sink 5 also moves in the f1 direction. In this case, the heat sink 5 and the chip withholding plate 4 may exert a large mounting pressure on the bare chip 1. Because the bare chip 1 is not protected by the metal cover, the bare chip 1 cannot bear the large mounting pressure. Otherwise, the bare chip 1 is easily damaged. To prevent the bare chip 1 from being damaged when press-mounted onto the mounting base 2, the chip withholding plate 4 may be movably connected to the heat sink 5. Specifically, when the chip withholding plate 4 press-mounts the bare chip 1 onto the mounting base 2 in the direction f1, because the heat sink 5 abuts against the bare chip 1, the bare chip 1 may generate a mounting stress in a direction f2 due to a press-mounting operation of the chip withholding plate 4 in the direction f1, and the heat sink 5 may move in the direction f2 relative to the chip withholding plate 4 due to the generated mounting stress. In this way, the mounting pressure generated by the heat sink 5 on the bare chip 1 is reduced, to ensure stability and reliability of mounting the bare chip 1, and also ensure quality and effectiveness of heat dissipation of the bare chip 1.

A chip package structure provided in this embodiment includes a bare chip 1 and a chip withholding plate 4. The bare chip 1 may be mounted on a circuit board 3 through a mounting base 2 provided with flexible contact terminals 201. Specifically, the bare chip 1 may be press-mounted onto the mounting base 2 through the chip withholding plate 4. In addition, a heat sink 5 may be used to perform a heat dissipation operation on the bare chip 1. This effectively enables the heat sink 5 to continuously perform the heat dissipation operation on the bare chip 1 while the chip withholding plate 4 is used to press-mount the bare chip 1 onto the mounting base 2, thereby ensuring safe and reliable operation of the bare chip 1. Moreover, because the heat sink 5 can move relative to the chip withholding plate 4 based on a generated mounting stress, the chip withholding plate 4 and the heat sink 5 do not exert a large mounting pressure on the bare chip 1, to prevent damage to the bare chip 1, thereby reducing manufacturing costs of the package structure, ensuring stable and reliable use of the bare chip 1, and further enhancing practicality of the package structure.

FIG. 2 is a schematic structural diagram of a bare chip abutting against flexible contact terminals according to an embodiment of the present disclosure. Based on the foregoing embodiment, referring to FIG. 1 to FIG. 2, because a packaging operation is not performed on the bare chip 1, during mounting of the bare chip 1, to prevent damage to the bare chip 1 as much as possible, the package structure in this embodiment may further include a chip metal ring 6. The chip metal ring 6 is disposed between the mounting base 2 and the chip withholding plate 4. The chip metal ring 6 may be connected to the bare chip 1. The bare chip 1 is disposed in a central portion or on a side of the chip metal ring 6. Specifically, the bare chip 1 may be mounted and connected to the chip metal ring 6 through a detachable connecting member, or the bare chip 1 may be fixedly connected to the chip metal ring 6. When the bare chip 1 is mounted on the chip metal ring 6, the bare chip 1 may abut against the flexible contact terminals 201 through the chip metal ring 6, and the chip metal ring 6 may protect the bare chip 1 and an edge of the bare chip 1, thereby effectively preventing damage to the bare chip 1 during mounting, and further ensuring mounting reliability of the bare chip 1.

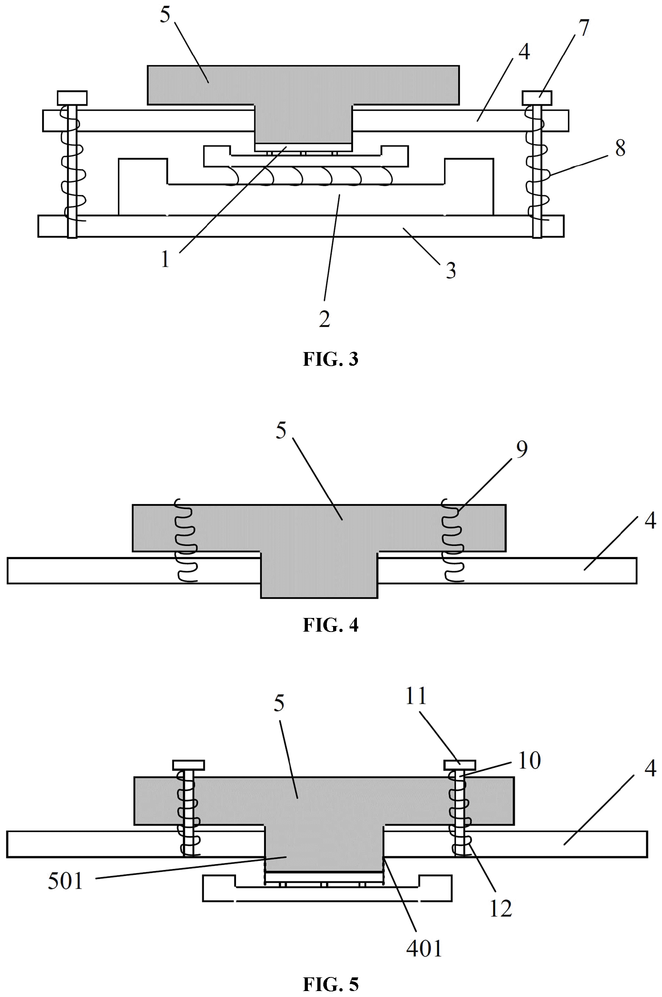

FIG. 3 is a schematic structural diagram 2 of a chip package structure according to an embodiment of the present disclosure. Based on the foregoing embodiment, referring to FIG. 1 to FIG. 3, a mounting manner between the chip withholding plate 4 and the circuit board 3 is not limited in this embodiment. To facilitate maintenance or an adjustment operation on the package structure, the chip withholding plate 4 in this embodiment may be mounted on the circuit board 3 through a detachable connecting member 7.

The detachable connecting member 7 may be implemented as any one of the following: a screw, a stud, a bolt, a rivet, or the like. In addition, to ensure that the chip withholding plate 4 can be stably mounted on the circuit board 3, the chip withholding plate 4 may be mounted on the circuit board 3 through a plurality of detachable connecting members 7. For example, the chip withholding plate 4 may be mounted on the circuit board 3 through two, four, or eight detachable connecting members 7.

When the chip withholding plate 4 is mounted on the circuit board 3 by using the detachable connecting member 7, to ensure stability and reliability of a mounting operation, the detachable connecting member 7 may be provided with a first elastic member 8. The first elastic member 8 may be implemented as a spring sleeved on the detachable connecting member 7. The first elastic member 8 is configured to absorb a mounting tolerance of the bare chip 1 in a process of mounting of the bare chip 1 onto the circuit board 3, and can also ensure a buffer effect for the mounting pressure between the chip withholding plate 4 and the circuit board 3, thereby further ensuring stability and reliability of detachable mounting of the chip withholding plate 4 and the circuit board 3.

FIG. 4 is a schematic structural diagram 1 of a connection between a chip withholding plate and a heat sink according to an embodiment of the present disclosure. Based on the foregoing embodiments, referring to FIG. 1 to FIG. 4, a specific connection manner between the chip withholding plate 4 and the heat sink 5 is not limited in this embodiment, and a person skilled in the art may perform flexible configuration according to structural features of implementation of the connection. For example, the chip withholding plate 4 may be movably connected to the heat sink 5 directly through an elastic member 9. The elastic member 9 not only enables the heat sink 5 to move relative to the chip withholding plate 4, but also enables the heat sink 5 to remain in abutment with the upper surface of the bare chip 1, so that the heat dissipation operation can be maintained on the bare chip 1.

To achieve the foregoing mounting effect between the heat sink 5 and the chip withholding plate 4, for the elastic member 9, an elasticity modulus of the elastic member 9 needs to be greater than or equal to a preset threshold. In this way, it can be ensured that the heat sink 5 remains in abutment with the upper surface of the bare chip 1. In addition, when the chip withholding plate 4 is used to press-mount the bare chip 1 onto the mounting base 2, the heat sink 5 can move relative to the chip withholding plate 4 based on the generated mounting stress, thereby effectively enabling the chip withholding plate 4 to be stably and movably connected to the heat sink 5.

FIG. 5 is a schematic structural diagram 2 of a connection between a chip withholding plate and a heat sink according to an embodiment of the present disclosure. Based on the foregoing embodiments, referring to FIG. 1 to FIG. 5, the chip withholding plate 4 may not only be movably connected to the heat sink 5 directly through the elastic member 9, but also be movably connected to the heat sink 5 through a detachable connecting member 10. An upper end of the detachable connecting member 10 is provided with a limiting member 11, and the limiting member 11 is configured to limit a range within which the heat sink 5 moves relative to the chip withholding plate 4.

The detachable connecting member 10 may include any one of the following: a connecting column or a spring connecting member. When the detachable connecting member 10 is implemented as the connecting column, a second elastic member 12 may be sleeved on the connecting column. The second elastic member 12 is configured to absorb a mounting tolerance in a process of mounting of the bare chip 1 on the circuit board 3 through the mounting base 2. In addition, the second elastic member 12 can also ensure a buffer effect for the mounting pressure between the chip withholding plate 4 and the heat sink 5, thereby effectively enabling the chip withholding plate 4 to be stably and movably connected to the heat sink 5.

Further, still referring to FIG. 1 to FIG. 5, to ensure quality and effectiveness of heat dissipation of the bare chip 1 by the heat sink 5, the heat sink 5 may include a heat dissipation boss 501 configured to abut against the upper surface of the bare chip 1. The chip withholding plate 4 is provided with a mounting through hole 401 corresponding to the heat dissipation boss 501, and the heat dissipation boss 501 abuts against the upper surface of the bare chip 1 through the mounting through hole 401. A size of the mounting through hole 401 may be adapted to a size of the heat dissipation boss 501, and the size of the heat dissipation boss 501 is the same as or different from a size of the upper surface of the bare chip 1, that is, the size of the heat dissipation boss 501 may be greater than, less than, or equal to the size of the upper surface of the bare chip 1.

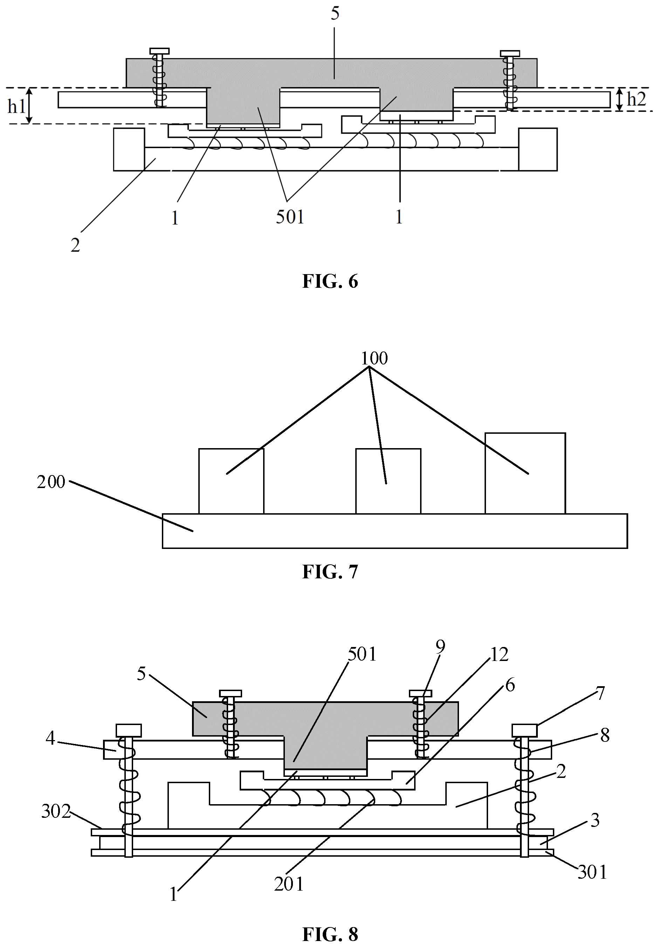

FIG. 6 is a schematic structural diagram 3 of a chip package structure according to an embodiment of the present disclosure. Based on the foregoing embodiments, referring to FIG. 1 to FIG. 6, for the bare chip 1 included in the package structure, one or more bare chips 1 may be provided. When a plurality of bare chips 1 are provided, the heat sink 5 may include a plurality of heat dissipation bosses 501 configured to perform the heat dissipation operation on the plurality of bare chips 1, and heights of the plurality of heat dissipation bosses 501 are the same or different.

For example, two bare chips 1 may be mounted on the mounting base 2, and sizes, dimensions, and heights of the two bare chips 1 are respectively different. To accurately mount the two bare chips 1 on the circuit board 3 at the same time through the mounting base 2 while ensuring quality and effectiveness of heat dissipation of the two bare chips 1, the heat sink 5 may be provided with two heat dissipation bosses 501. One of the heat dissipation bosses 501 may have a height h1, and the other of the heat dissipation bosses 501 may have a height h2, where h1 is not equal to h2. The two heat dissipation bosses 501 may respectively abut against the two bare chips 1 of different heights, to ensure the quality and effectiveness of heat dissipation of the two bare chips 1.

Similarly, when the plurality of bare chips 1 are mounted on the circuit board 3, the heat sink 5 may be provided with a plurality of heat dissipation bosses 501 configured to perform the heat dissipation operation on the plurality of bare chips 1, and sizes, dimensions, and heights of the plurality of heat dissipation bosses 501 may be the same or different. The heat dissipation operation may be performed on the plurality of bare chips 1 through the plurality of heat dissipation bosses 501 that abut against the plurality of bare chips 1, and heat dissipation quality and effectiveness are ensured, thereby improving stability and reliability of the bare chips 1 in use.

In this embodiment, one or more bare chips 1 may be provided in the package structure. Correspondingly, the heat sink 5 may include one or more heat dissipation bosses 501 configured to perform the heat dissipation operation on the one or more bare chips 1. A person skilled in the art may flexibly configure and adjust the number and structural features of bare chips 1 and heat dissipation bosses 501 according to a specific application requirement or design requirement, thereby effectively improving flexibility and reliability of the package structure in use.

FIG. 7 is a schematic structural diagram of a chip package structure according to an embodiment of the present disclosure. Referring to FIG. 7, this embodiment provides an electronic apparatus. The electronic apparatus may include a base plate 200; and the chip package structure 100 in the foregoing embodiment. At least one package structure 100 is provided, and the package structure 100 is detachably mounted on the base plate 200.

A specific shape structure, an implementation function, and an implementation effect of the package structure 100 in this embodiment are similar to a specific shape structure, an implementation function, and an implementation effect of the package structure in the foregoing embodiment. For details, refer to the foregoing descriptions, and details are not described herein again.

In some embodiments, the chip package structure 100 may be mounted on the base plate 200 through a back plate, and the back plate may effectively ensure use strength of the chip package structure 100.

In the electronic apparatus of this embodiment, one or more chip package structures 100 are configured on the base plate 200, to implement an electronic apparatus with a preset function. The package structure 100 can not only ensure heat dissipation quality and effectiveness, but also facilitate a mounting operation on the package structure 100, and is not easily damaged, thereby reducing manufacturing costs of the electronic apparatus, effectively ensuring stable and reliable operation of the electronic apparatus, and further improving practicality of the electronic apparatus.

During specific application, referring to FIG. 8, an example in which a land grid array (LGA) socket is used as a mounting base and a PCBA board is used as a circuit board is used. This embodiment provides a bare chip package structure. Specifically, the package structure may include: a PCBA board 3, configured to deploy at least one bare chip 1 and other electronic components (not shown in the figure). The electronic component may form a preset connecting line with the at least one deployed bare chip 1, to implement the preset function such as an image processing function or a signal processing function, etc. The other electronic components may include at least one of the following: a resistor, an inductor, a capacitor, and the like.

A support lower back plate 301 is disposed on a back surface of the PCBA board 3. Specifically, the support lower back plate 301 may be fixedly connected to the PCBA board through a connecting member, an adhesive, or a soldering manner, to enhance strength of the PCBA board 3, so that use of the PCBA board 3 is more stable and reliable.

A support upper back plate 302 is disposed on a front surface of the PCBA board 3. Specifically, the support upper back plate 302 may be fixedly connected to the PCBA board through a connecting member, an adhesive, or a soldering manner, to enhance strength of the PCBA board 3, so that use of the PCBA board 3 is more stable and reliable.

An LGA socket 2 is soldered to the PCBA board 3, and the LGA socket 2 is provided with a plurality of flexible contact terminals 201 configured to be in contact with the bare chip 1.

The bare chip 1 is disposed at a central portion of a chip metal ring 6, to abut against the flexible contact terminals 201 through the chip metal ring 6.

A chip withholding plate 4 is detachably connected to the PCBA board 3, the support lower back plate 301, and the support upper back plate 302 through a plurality of detachable connecting members 7. The detachable connecting member 7 may be implemented as a screw, and the screw may be provided with a first elastic member 8, such as a spring, configured to absorb a manufacturing tolerance of the package structure.

A heat sink 5 is movably connected to the chip withholding plate 4 through a plurality of detachable connecting members 10. The detachable connecting member 10 may be implemented as a connecting column and a limiting portion disposed at an upper end of the connecting column, and the connecting column may be provided with a second elastic member 12, such as a spring member, configured to absorb the manufacturing tolerance of the package structure. The heat sink 5 may include one or more heat dissipation bosses 501. The heat dissipation boss 501 may be in contact with an upper surface of the bare chip 1 through a mounting through hole located in the chip withholding plate 4. Specifically, the heat dissipation boss 501 may be in contact with the upper surface of the bare chip 1 through a heat conductive member or a heat conductive material, to perform a heat dissipation operation on the bare chip 1.

It should be noted that, when the chip withholding plate 4 is used to press-mount the bare chip 1 onto the mounting base 2, the heat sink 5 can move relative to the chip withholding plate 4 based on a mounting stress generated from press-mounting the bare chip onto the mounting base, and the heat sink 5 remains in abutment with the upper surface of the bare chip 1 to perform the heat dissipation operation on the bare chip 1.

The package structure provided in this embodiment of the present disclosure can resolve problems existing in the related art that when a bare chip is mounted through an LGA socket, the bare chip may be damaged or the bare chip is seriously deformed under a relatively large pressure (200 kgf), and the bare chip cannot be in reliable contact with a heat sink. Specifically, the chip withholding plate 4 and the heat sink 5 corresponding to the bare chip 1 are coupled together. When the chip withholding plate 4 applies a mounting pressure to the bare chip 1 and the PCBA board 3, the heat sink 5 is driven to apply a stable pressure to an area in which the bare chip 1 is located. The pressure and an elastic force generated by the flexible contact terminals 201 of the LGA socket 2 form a stable counter-pressure elimination, so that the stress on the bare chip 1 is more uniform, thereby effectively preventing the bare chip 1 from upward arching deformation or damage. In addition, the bare chip 1 is mounted on the PCBA board 3 through the LGA socket 2, thereby reserving advantages of an LGA packaging technology. The advantages specifically include: convenient maintenance, low costs, and being capable of flexibly switching and reconfiguring various chip models. In this way, stable and reliable use of the chip package structure is further ensured.

Finally, it should be noted that the foregoing embodiments are merely intended for describing the technical solutions of the present disclosure, but not for limiting the present disclosure. Although the present disclosure is described in detail with reference to the foregoing embodiments, a person of ordinary skill in the art should understand that they may still make modifications to the technical solutions described in the foregoing embodiments or make equivalent replacements to some technical features thereof, and such modifications or replacements do not cause the essence of corresponding technical solutions to depart from the spirit and scope of the technical solutions in the embodiments of the present disclosure.

## Claims

1. A chip package structure, comprising:
a bare chip mounted on a circuit board through a mounting base, wherein the mounting base comprises a plurality of flexible contact terminals configured to abut against the bare chip, to enable the bare chip to form a connecting line with the circuit board through the flexible contact terminals; and
a chip withholding plate configured to press-mount the bare chip onto the mounting base, wherein the chip withholding plate is connected to a heat sink, and when the chip withholding plate is used to press-mount the bare chip onto the mounting base, the heat sink is capable of moving relative to the chip withholding plate based on a mounting stress generated from press-mounting the bare chip onto the mounting base, and the heat sink remains in abutment with an upper surface of the bare chip to perform a heat dissipation operation on the bare chip.

2. The chip package structure according to claim 1, wherein a direction in which the heat sink moves relative to the chip withholding plate is opposite to a mounting direction of the bare chip.

3. The chip package structure according to claim 1, wherein
the mounting base is a land grid array socket, and the mounting base is fixedly mounted on the circuit board.

4. The chip package structure according to claim 1, further comprising:
a chip metal ring connected to the bare chip, wherein the bare chip is disposed at a central portion of the chip metal ring, to abut against the flexible contact terminals through the chip metal ring.

5. The chip package structure according to claim 1, wherein
the chip withholding plate is mounted on the circuit board through a detachable connecting member.

6. The chip package structure according to claim 5, wherein
the detachable connecting member is provided with a first elastic member, and the first elastic member is configured to absorb a mounting tolerance in a process of mounting of the bare chip onto the circuit board.

7. The chip package structure according to claim 1, wherein the chip withholding plate is movably connected to the heat sink through a detachable connecting member, and an upper end of the detachable connecting member is provided with a limiting member, wherein the limiting member is configured to limit a range within which the heat sink moves relative to the chip withholding plate.

8. The chip package structure according to claim 7, wherein the detachable connecting member comprises any one of: a connecting column, and a spring connecting member.

9. The chip package structure according to claim 8, wherein when the detachable connecting member is the connecting column, the connecting column is provided with a second elastic member.

10. The chip package structure according to claim 1, wherein the heat sink comprises a heat dissipation boss configured to abut against the upper surface of the bare chip, the chip withholding plate is provided with a mounting through hole corresponding to the heat dissipation boss, and the heat dissipation boss abuts against the upper surface through the mounting through hole.

11. The chip package structure according to claim 10, wherein a size of the heat dissipation boss is same as or different from a size of the upper surface.

12. The chip package structure according to claim 10, wherein a plurality of bare chips are provided, the heat sink comprises a plurality of heat dissipation bosses configured to perform the heat dissipation operation on the plurality of bare chips, and heights of the plurality of heat dissipation bosses are same or different.

13. The chip package structure according to any one of claims 1 to 12, wherein the heat sink abuts against the upper surface of the bare chip through a heat conductive member.

14. An electronic apparatus, comprising:
a base plate; and
the chip package structure according to any one of claims 1 to 13, wherein the chip package structure is detachably mounted on the base plate.
